# EUROPEAN PATENT APPLICATION

(11) **EP 0 830 053 A2**
(43) Date of publication of application: **18.03.1998**
(21) Application number: 97115954.6
(22) Date of filing: 12.09.1997
(51) Int. Cl.: H05K 1/16, H01F 27/28

(54) **Coil included printed wiring board**

(30) Priority: 12.09.1996 JP 241546/96
(71) Applicant: NEC CORPORATION, Tokyo (JP)
(72) Inventor: Kakuta, Yuuji, Minato-ku, Tokyo (JP)
(74) Representative: Glawe, Delfs, Moll & Partner

(57) **Abstract**

A coil included printed wiring board in which a dielectric substrate is constructed in a film-like form due to being made of a flexible material. On the dielectric substrate, an electronic-parts-mounting conductive pattern and a coil conductive pattern are formed as one. The coil conductive pattern is shaped in such manner that an inductance coil is to be constructed under the state in which the dielectric substrate is folded. The dielectric substrate has penetration holes being opened at the inner side of the inductance coil. These penetration holes have a core made of a ferromagnetic material penetrating through them.

## Description

### BACKGROUND OF THE INVENTION

The present invention relates to a coil included printed wiring board in which a printed wiring substrate is being integrated with a coil.

### Description of the Related Art

Conventionally, as for the printed wiring boards used for hybrid integrated circuits etc., they often mount inductance coils and transformers in addition to chip parts like semiconductor devices and resistors. As to such inductance coils and transformers to be mounted on the printed wiring board of such type, there are, for example, ones that are disclosed in the Japanese Patent Laid-Open Publication No. 4-349604.

The inductance coil disclosed in the conventional invention is constructed in a cylindrical manner by having a loop-shaped coil pattern on a film-like printed board made of a flexible material being wrapped around a cylinder-shaped bobbin. Moreover, the transformer indicated in the conventional invention has a configuration in which a core being made of a ferromagnetic material penetrates the bobbin of the above mentioned cylinder-shaped inductance coil. Furthermore, in order to have the inductance coil and transformer mounted on the printed wiring board of the hybrid integrated circuit or the like, the printed wiring board should take a configuration in which a wire has one end of it soldered to a land section of the coil pattern while it has the other end of it soldered to a wiring pattern of the mentioned printed wiring board.

In order to have the other end of the mentioned wire soldered to the printed wiring board, in most cases for example, the configuration of the printed wiring circuit board takes after the one that is disclosed in the Japanese Patent Laid-Open Publication No. 62-8590. According to the mounting configuration of the conventional printed wiring board, there are provided a through holes on the printed wiring board and inserted a lead on the provided concave part of the printed wiring board so that the inductance coil and the transformer can be temporarily be kept on the printed wiring board before being soldered. By taking this configuration, it is possible to have the above-mentioned chip parts, the inductance coil, the transformer and the like supplied to the reflow furnace and soldered by reflow soldering while having them being mounted on the surface of the printed wiring board.

However, there has been noted the problem that a mounting density of the electronic parts to be mounted on the printed wiring board can not be increased as long as the wire is soldered to the wiring pattern of the printed wiring board for the purpose of mounting the inductance coil and the transformer on the printed wiring board. That is to say, in order to solder the wire to the printed wiring board, it is necessary to adopt to the wiring pattern of the printed wiring board an electrode pattern for soldering, which leads to a disadvantage of enlarging the size of the printed wiring board by the space required for the electrode pattern. Especially, when mounting the inductance coil and the transformer on the printed wiring board for the hybrid integrated circuit, the whole size of the printed wiring board is to increase remarkably due to having the through hole and the concave part on the printed wiring board so that the inductance coil and the transformer can be soldered by reflow soldering.

Furthermore, as for the inductance coil and the transformer, on attempting to solder them on the printed wiring board by reflow soldering, there has often been a failure on the soldering. This is due to the fact that the temperature of the soldered part at the time of reflow soldering does not rise high enough since the inductance coils and the transformer are larger in sizes and heat capacities when compared with the chip parts.

### SUMMARY OF THE INVENTION

Therefore, the present invention has been achieved with an object of overcoming the above problems as well as providing a smaller-size coil included printed wiring board having high reliability on a coil connection part.

In accordance with a first aspect of the present invention, there is provided a coil included printed wiring board having a printed wiring substrate constructed in a film-like form due to being made of a flexible material. On the the printed wiring substrate there are being applied an electronic-parts-mounting conductive pattern and a coil conductive pattern which are formed as one. The coil conductive pattern is constructed by the printed wiring substrate being folded to form a coil. On the printed wiring substrate, penetration holes are being opened at the inner side of the coil. While the printed wiring substrate holds its state of being folded, a core made of a ferromagnetic material penetrates the penetration holes.

According to the present invention, there is constructed a stereoscopic inductance coil due to having the printed wiring substrate folded and the core adopted. Thus, with respect to the printed wiring board corresponding to the preset invention, there is no need for any soldering in order to set up a coil since a part of the printed wiring substrate is forming the coil.

In accordance with a second aspect of the present invention, the printed wiring board introduced in the first aspect of the invention is provided with stoppers at both ends of the core where the core penetrates the folded printed wiring substrate. The stoppers are arranged in a manner in which they are facing against the main surfaces of the printed wiring substrate. Consequently, according to the present invention, the stoppers provided to the core are to prevent the printed wiring substrate being folded in order to form a coil, from springing back by its elasticity to recover its original state.

In accordance with a third aspect of the present invention, the printed wiring board introduced in the first aspect of the invention is provided with a printed wiring substrate being folded in a shape of S, having three penetration wholes.

In accordance with a forth aspect of the present invention, the printed wiring board introduced in the first aspect of the invention is provided with a printed wiring substrate being folded in a shape of U, having two penetration wholes.

The above and further objects and the novel feature of the invention will more fully appear from the following detailed description when the same is read in connection with the accompanying drawings. It is to be expressly understood, however, that the drawings are for illustration only and are not intended as a definition of the limits of the invention.

### BRIEF DESCRIPTION OF THE DRAWINGS

Fig. 1 is an exploded perspective view of a hybrid integrated circuit applying the coil included printed wiring board according to the present invention;
Fig. 2 is a plan view of the printed wiring board according to the present invention; and
Fig. 3 is a diagram illustrating another state of embodiment of the coil included printed wiring board according to the present invention.

### DESCRIPTION OF THE PREFERRED EMBODIMENTS

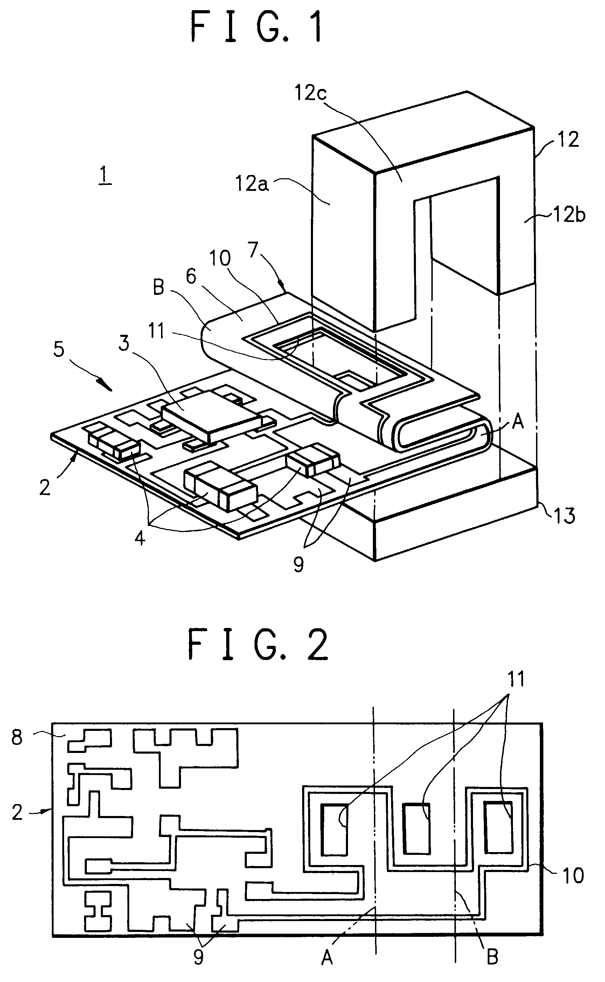

First of all, there will be a description of a first embodiment of the coil included printed wiring board corresponding to the present invention, with reference to Figs. 1 and 2. Here what is to be described is the coil included printed wiring board when being applied to the hybrid integrated circuit operating as an amplifier. Fig. 1 is a perspective deal view of a hybrid integrated circuit applying the coil included printed wiring board according to the present invention. Fig. 2 is a plan view of the printed wiring board.

In those two diagrams, code 1 indicates a hybrid integrated circuit of the present embodiment. The hybrid integrated circuit 1 comprises, a high-frequency circuit section 5 having a semiconductor device 3 being surface mounted on a printed wiring board, chip parts 4 including resistance and capacitance etc., and so forth, and a power source section 7 including an inductance coil 6, which will be described later.

As it is shown in Fig. 2, the printed wiring board 2 is forming an electronic-parts-mounting conductive pattern 9, and a coil conductive pattern 10 on the surface of a dielectric substrate 8 formed in a film-like state being manufactured with a flexible synthetic resin. According to the present invention, this dielectric substrate 8 is substantially constructing the printed wiring board. Both of the conductive patterns 9 and 10 are shaped in prescribed shapes and being integrated due to having a copper foil arranged to the dielectric substrate 8 being etched.

The coil conductive pattern 10 is constructed in a manner in which the dielectirc substrate 8 is folded so that a two-dot chain line A becomes a valley line, and a two-dot chain line B becomes a hill line as shown in Fig. 2., thus forming an inductance coil 6 which is obvious when looking from above. At the central part of the inductance coil 6, there is provided penetration holes 11, to which the core, which will be touched upon later, is adopted. The penetration holes 11 are provided at three places on the dielectric substrate 8. Three of the penetration holes 11 are given in such manner that they have the same rectangular shapes of the same sizes. The penetration holes 11 have the U-shaped core 12 piercing through them under the state in which the dielectirc substrate 8 is folded in a way that the inductance coil 6 is formed.

In accordance with the present embodiment, the coil conductive pattern 10 is being stretch-provided around the penetration holes 11 at three places in a similar way of drawing a line with a single stroke of a brush. Moreover, the dielectric substrate 8 is folded in a fashion that there should be constructed the inductance coil 6 being composed of a tow-turn solenoid coil. Furthermore, according to the present embodiment, in order to avoid the coil conductive pattern 10 to touch itself while being provided on the dielectric substrate 8 being folded, the coil conductive pattern 10 is to be covered with an insulating film, which is not shown.

The aforesaid U-shaped core 12 is made of a ferromagnetic material sectionally formed in a shape of U as one body. One side 12a is piercing through the penetration holes 11 while the opened ends are being glued to a ferromagnetic flat board 13. Thus, by having the U-shaped core 12 fixed to the ferromagnetic flat board 13, the open ends of the U-shaped core 12 is magnetically closed. When energizing the inductance coil 6 under the condition that the U-shaped core 12 is being fixed to the ferromagnetic flat board 13, there is to be generated a magnetic loop of a toroidal system. This occurs due to having one side 12a, the other side 12b, and an upper side 12c of the U-shaped core 12, as well as the ferromagnetic flat board 13 form a magnetic circuit. In accordance with the present embodiment, the construction combination of the U-shaped core 12 and the ferromagnetic flat board 13 is forming the core of the present invention.

In order to produce the printed wiring board 2 as it has been described above, the dielectric substrate 8 is to have the semiconductor device 3 and the chip parts 4 mounted on it for example, by means of reflow soldering before the coil conductive pattern 10 provided on the dielectric substrate 8 is folded in a way shown in Fig. 1. Moreover, the core being constructed with the U-shaped core 12 and the ferromagnetic flat board 13 is to be adopted.

Accordingly, as for the printed wiring board 2 constructed in such way, there is no need for practicing any soldering in order to set up the coil since the part of the dielectric substrate 8 is constituting the stereoscopic inductance coil 6. Furthermore, by having the U-shaped core 12 piercing through the penetration holes 11, the inductance coil 6 is to take up a form of a core included coil of which inductance is to increase. Moreover, by closing the open ends of the U-shaped core 12 with the ferromagnetic flat board 13, there is constructed the core of the toroidal system, which leads to the advantage of minimizing the electric loss generated by the core.

In addition, due to having the core of the inductance coil 6 constructed with the U-shaped core 12 and the ferromagnetic flat board 13, the upper side 12c of the U-shaped core 12 and the ferromagnetic flat board 13 connected to both ends of the part (side 12a) penetrating the dielectric substrate 8 substantially serve as stoppers. This is to prevent the dielectric substrate 8 from spreading by its elasticity. That is, since the upper side 12c of the U-shaped core 12 and the ferromagnetic flat board 13 are facing against the main surfaces (front and back), the stretching of the part of the dielectric substrate 8 being folded can be kept to a minimum.

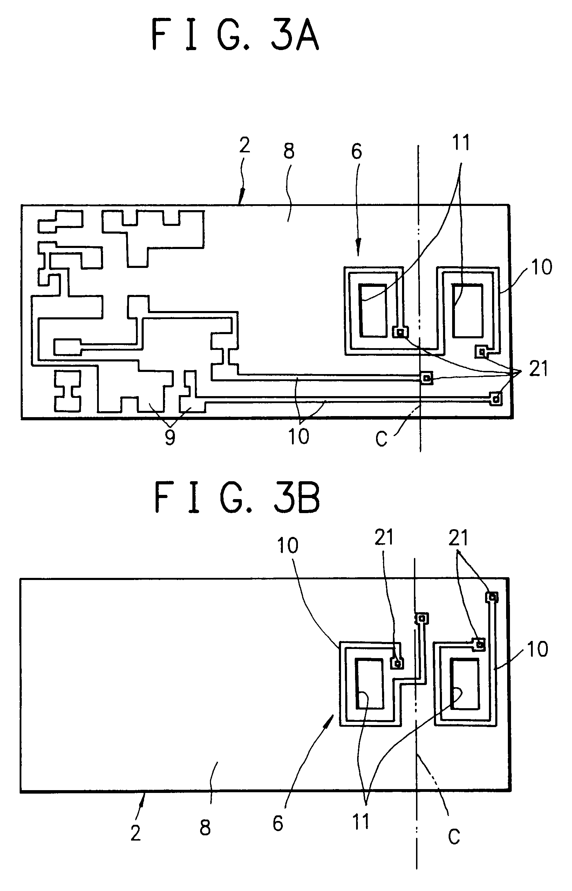

Next, there will be a detailed description of a second embodiment of the coil included printed wiring board according to the present invention, with reference to Fig. 3. Fig. 3 is a diagram showing the coil included printed wiring board. (a) of Fig. 3 is showing the upper side while (b) of Fig. 3 is showing the base of the printed wiring board. As for the same or the equivalent constituent parts already being described with reference to Figs. 1 and 2, the same codes are to be used and a detailed explanation of them will be omitted.

The coil pattern 10 shown in Fig. 3 is folded at a two-dot chain line C so as to construct the inductance coil 6. More specifically, the penetration holes 11 are opened at two places on the dielectric substrate 8 so that the holes are placed at the heart of the inductance coil 6. This coil conductive pattern 10 is formed on the front side (the mounting surface) and the reverse side of the dielectric substrate 8 around the penetration holes 11.

The coil conductive pattern 10 on the front side of the dielectric substrate 8 and that on the back side of the dielectric substrate 8 become conductive against each other due to through holes 21. In addition, by having the dielectric substrate 8 folded at the two-dot chain line C, there is constructed a four-turn solenoid coil. Moreover, the penetration holes 11 have a core having the same structure as that applied to the first embodiment attached to it. Consequently, due to having the core adopted, the inductance coil 6 is to take a form of a core included coil of which inductance is to be augmented. Therefore, even when the inductance coil 6 is constructed by using both the front and the back sides of the dielectric substrate 8, the same effect and advantage can be acquired as in the case of the first embodiment.

Moreover, although both the first and the second embodiments have been used in describing the examples in which the present invention is applied to the circuit substrate for hybrid integrated circuit, the present invention is not to be restricted by those particular embodiments. The present invention is subjected to being applied to any coil-loaded printed wiring board. Furthermore, though the coil is taking a form of a choke coil with two ends, according to the above-mentioned embodiments, the present invention is not to be limited to such a form but can take a form of a transformer having four ends. It is also possible to obtain an impedance matching due to having this transformer.

In case of the first embodiment, the two-turn coil is composed of a copper pattern having a width of 0.1mm and a thickness of 30 µm. Moreover, as for the material used for the U-shaped core 12 and the ferromagnetic flat board 13, ferrite of a Ni-Zn system is adopted. Since the inductance coil 6 constructed under such conditions is to have the inductance of some score µH, the inductance coil 6 is capable of being used as a choke coil of an amplifier of more than some score MH_{z} . Furthermore, regarding the material used for the dielectric substrate 8, as for the cases of the first and the second embodiments, a synthetic resin of a polyimide type having a thickness of about 30 µm is employed. Since this polyimide-type synthetic resin is high in flexibility, the dielectric substrate 8 can be easily folded, and never cracks or break in stead of folding.

Hence, described as above, according to the first aspect of the present invention, there is provided a coil included printed wiring board having a printed wiring substrate constructed in a film-like form due to being made of a flexible material. On the the printed wiring substrate there are being applied an electronic-parts-mounting conductive pattern and a coil conductive pattern which are formed as one. The coil conductive pattern is constructed by the printed wiring substrate being folded to form a coil. On the printed wiring substrate, penetration holes are being opened at the inner side of the coil. While the printed wiring substrate holds its state of being folded, a core made of a ferromagnetic material penetrates the penetration holes. Thus, there is constructed the stereoscopic inductance coil due to having the printed wiring substrate including the coil conductive pattern folded, as well as having the core adopted to it.

Accordingly, regarding the printed wiring board corresponding to the preset invention, the coil can be set up without the need for any soldering. Consequently, it enables the miniaturization of the printed wiring board as compared with the conventional printed wiring board constructing on itself the electrode pattern for soldering for the purpose of connecting the coil. Moreover, since there is no soldering section in between the coil and the electronic-parts-mounting conductive pattern, the reliability of the coil connection is high.

According to the second aspect of the present invention, the printed wiring board introduced in the first aspect is provided with stoppers at both ends of the core where it penetrates the folded printed wiring substrate. The stoppers are arranged in a manner in which they are facing against the main surfaces of the printed wiring substrate. Consequently, according to the present invention, the stoppers provided to the core are to prevent the printed wiring substrate being folded in order to form a coil, from springing back by its elasticity to recover its original state.

Therefore, since the constituent parts of the coil can be employed in maintaining the printed wiring substrate in the state of being folded, the number of parts used in constructing the coil included printed wiring board can be kept to a minimum.

According to the third aspect of the present invention, the printed wiring board introduced in the first aspect is provided with a printed wiring substrate being folded in a shape of S, having three penetration holes.

According to the fourth aspect of the present invention, the printed wiring board introduced in the first aspect is provided with a printed wiring substrate being folded in a shape of U, having two penetration holes .

Hence, for the same reasons given for the first and the second aspects of the present invention, the third and the fourth aspects of the invention indicate that the miniaturization of the printed wiring board and high reliability of a coil connection part are achievable, and that the number of parts used in constructing the printed wiring board can be kept to a minimum.

While preferred embodiments of the invention have been described using specific terms, such description is for illustrative purposes only, and it is to be understood that changes and variations may be made without departing from the spirit or the scope of the following claims.

## Claims

1. A coil included printed wiring substrate comprising:
a printed wiring substrate being constructed in a film-like form due to being made of a flexible material;
an electronic-parts-mounting conductive pattern constructed on the printed wiring substrate; and
a coil conductive pattern constructed on the printed wiring substrate by having the printed wiring substrate being folded to form a coil; wherein,
the electronic-parts-mounting conductive pattern and the coil conductive pattern are being formed as one, and
the printed wiring substrate has penetration holes being opened at the inner side of the coil and a core made of a ferromagnetic material penetrating the penetration holes while the printed wiring substrate holds its state of being folded to form the coil.

2. A printed wiring substrate according to claim 1, wherein the core, at the spot where it penetrates the folded printed wiring substrate has stoppers at both ends, arranged in a manner in which the stoppers are facing against the main surfaces of the printed wiring substrate.

3. A printed wiring substrate according to claim 1, wherein the printed wiring substrate includes three penetration wholes and are being folded in a shape of S.

4. A printed wiring substrate according to claim 1, wherein the printed wiring substrate includes two penetration wholes and are being folded in a shape of U.
